# EUROPÄISCHE PATENTANMELDUNG

(11) **EP 2 905 888 A1**
(43) Veröffentlichungstag der Anmeldung: **12.08.2015**
(21) Anmeldenummer: 14153916.3
(22) Anmeldetag: 05.02.2014
(51) Int. Cl.: H02M 7/00, H05K 9/00

(54) **Stromrichter**

(71) Anmelder: Grundfos Holding A/S, 8850 Bjerringbro (DK)
(72) Erfinder: Wolf, Christian, 8850 Bjerringbro (DK)
(74) Vertreter: Patentanwälte Vollmann & Hemmer

(57) **Zusammenfassung**

Der Frequenzumrichter weist eine Umhausung auf, in welcher elektrische und elektronische Bauelemente (5, 6, 7, 22) angeordnet sind und die zumindest teilweise als Faradayscher Käfig ausgebildet ist. Innerhalb der Umhausung sind mindestens zwei Faradaysche Käfige (4, 9, 15, 29) vorgesehen, um die EMV zu verbessern. (Fig. 1)

## Beschreibung

Die Erfindung betrifft einen Stromrichter, insbesondere einen Frequenzumrichter, mit den im Obergriff des Anspruchs 1 angegebenen Merkmalen.

Stromrichter werden heutzutage in vielen technischen Anwendungen eingesetzt. So zählt es beispielsweise bei Kreiselpumpen, die als Heizungsumwälzpumpen oder dergleichen eingesetzt werden, heutzutage zum Stand der Technik, diese mit einem Frequenzumrichter auszustatten, der in einem meist am Motorgehäuse angebrachten Klemmenkasten bzw. Frequenzumrichtergehäuse angeordnet ist. Derartige Frequenzumrichter weisen eine Vielzahl von elektronischen Bauelementen auf, von denen elektromagnetische und/oder elektrostatische Strahlungen als Störquelle ausgehen, welche abgeschirmt werden müssen, um die elektromagnetische Verträglichkeit (EMV) zu gewährleisten. Andererseits weisen solche Frenquenzumrichter auch empfindliche elektronische Bauelemente (Störsenke), insbesondere der Steuer- und Regelungselektronik, auf, die es vor elektromagnetischen und/oder elektrostatischen Einflüssen zu schützen gilt.

Hierzu zählt es zum Stand der Technik die den Stromrichter bildenden elektrischen und elektronischen Bauelemente mit einem Faradayschen Käfig zu umhausen.

Aus DE 297 22 918 Ul zählt es zum Stand der Technik, das gesamte Stromrichtergehäuse als Faradayschen Käfig auszulegen.

Trotz einer solchen vollständigen Abschirmung des Stromrichters mittels eines Faradayschen Käfigs kann es schwierig sein, die elektromagnetische Verträglichkeit des Stromrichters sicherzustellen. In der Praxis wird dies dadurch realisiert, dass zusätzlich die Schaltzeiten, insbesondere die Anstiegszeit und die Abfallzeit beim Schalten der elektronischen Schalter angepasst werden, um insbesondere im Bereich hoher Frequenzen eine geringere Störstrahlung zu erhalten. Dies hat allerdings den Nachteil, dass dadurch der Wirkungsgrad des Umrichters verschlechtert wird, also Verluste entstehen.

Auch zählt es zum Stand der Technik, große Entstörferrite um das Eingangskabel anzuordnen.

Vor diesem Hintergrund liegt der Erfindung die Aufgabe zugrunde, die vorstehend genannten Nachteile zu vermindern, also die elektromagnetische Verträglichkeit eines Stromrichters, insbesondere eines Frequenzumrichters, möglichst ohne Leistungseinbußen und ohne hohen konstruktiven Aufwand zu verbessern.

Diese Aufgabe wird gemäß der Erfindung durch einen Stromrichter mit den in Anspruch 1 angegebenen Merkmalen gelöst. Vorteilhafte Ausgestaltungen der Erfindung sind in den Unteransprüchen, der nachfolgenden Beschreibung und der Zeichnung angegeben. Dabei können die in den Unteransprüchen und der Beschreibung angegebenen Merkmale jeweils für sich aber auch in geeigneter Kombination die erfindungsgemäße Lösung gemäß Anspruch 1 weiter ausgestalten.

Der erfindungsgemäße Stromrichter, insbesondere Frequenzumrichter, weist eine Umhausung auf, in welcher elektrische und elektronische Bauelemente angeordnet sind, und die zumindest teilweise als Faradayscher Käfig ausgebildet ist. Gemäß der Erfindung weist die Umhausung zumindest zwei Faradaysche Käfige auf.

Grundgedanke der erfindungsgemäßen Lösung ist es, mindestens zwei Faradaysche Käfige vorzusehen, um auf diese Weise eine bessere elektromagnetische Trennung von Bauelementen oder Baugruppen innerhalb des Frequenzumrichters zu erreichen und damit die EMV zu verbessern.

Dabei ist es besonders vorteilhaft, wenn gemäß einer Weiterbildung der Erfindung zwei getrennte Faradaysche Käfige eine gemeinsame Käfigwand aufweisen. Eine solche Konstruktion ist hocheffektiv und durch die gemeinsame Nutzung einer Käfigwand auch kostengünstig. Eine Leiterdurchführung durch eine solche Wand erfolgt vorteilhaft mittels eines Durchführungskondensators.

Eine besonders vorteilhafte Ausgestaltung der Erfindung ergibt sich dadurch, dass ein oder mehrere Bauelemente, welche im Betrieb eine elektromagnetische und/oder elektrostatische Störquelle bilden, in zumindest einem Faradayschen Käfig und ein oder mehrere Bauelemente, welche empfindlich für den Empfang von elektromagnetischen und/oder elektrostatischen Störsignalen sind (Störsenke), in zumindest einem anderen Faradayschen Käfig angeordnet sind. Diese erfindungsgemäße Weiterbildung ist besonders effektiv, da mit den mindestens zwei Faradayschen Käfigen zum einen eine Abschirmung der Störsignale erzeugenden Bauelemente erfolgt und zum anderen eine Abschirmung für die für Störsignale besonders empfänglichen Bauelemente gebildet ist. Hierdurch kann die innerhalb des Stromrichters entstehende hochfrequente Störung ganz erheblich reduziert werden, insbesondere, wenn man die aus dem Stromrichter als Ganzes austretende Störstrahlung betrachtet und die Schaltzeiten müssen nicht mehr verlängert werden.

Dabei ist besonders vorteilhaft, wenn zumindest die elektronischen Schalter des Leistungskreises des Stromrichters, vorzugsweise der gesamte Leistungskreis in einem eigenen Faradayschen Käfig angeordnet sind. Der Leistungskreis des Stromrichters stellt typischerweise eine vergleichsweise große Störquelle dar, die vorteilhaft gesondert innerhalb des Stromrichters durch einen Faradayschen Käfig abgeschirmt wird.

Zusätzlich oder alternativ ist es besonders vorteilhaft, wenn mindestens einer oder eine Anzahl von Eingangs- oder Ausgangsstörfiltern in voneinander getrennten Faradayschen Käfigen angeordnet sind. Hierdurch kann wirksam eine Störstrahlung aus dem Stromrichter heraus verhindert werden.

Um zu verhindern, dass bei den Leitungsdurchführungen innerhalb des Stromrichters zwischen den Faradayschen Käfigen Störsignale übertragen werden, ist gemäß einer Weiterbildung der Erfindung ein Durchführungskondensator (feed through capacitor) in einer Wand zwischen zwei Faradayschen Käfigen vorgesehen. Dabei können in einer Wand ein oder mehrere solcher Durchführungskondensatoren vorgesehen sein, je nach Anzahl der durchzuführenden Leiter. Dabei kann es sich um Leiter zur Leitung elektrischer Signale und/oder zur Übertragung elektrischer Leistung von einem Käfig in den anderen Käfig handeln.

Um eine möglichst effektive Störstrahlverminderung zu erreichen, ist gemäß einer Weiterbildung der Erfindung mindestens ein Kondensator an einer Seite elektrisch mit der Wand des Faradayschen Käfigs und an der anderen Seite elektrisch mit dem Leiter verbunden, der durch die Durchführungsöffnung von einem Faradayschen Käfig zum anderen Faradayschen Käfig verläuft. Dabei ist die Wirkung umso besser, je näher dieser Kondensator mit seiner Wandseite an der Durchführungsöffnung elektrisch angebunden ist.

Ein solcher Kondensator, der hohe Frequenzen zum Faradayschen Käfig hin kurzschließt, ist vorteilhaft in dem Faradayschen Käfig vorgesehen, in dem ein Störsignal entsteht, oder wenn dieses von außen kommt, durch welchen ein solches Störsignal geführt wird.

Gemäß einer vorteilhaften Weiterbildung der Erfindung ist ein gesonderter Faradayscher Käfig vorgesehen, der einen Ausgangsfilterkäfig des Stromrichters bildet, der zwei oder mehr leistungsführende Leiter zu einem Motor und mindestens einem Kondensator aufweist, der zwischen einem Leiter und der Wand des Ausgangsfilterkäfigs geschaltet ist. Diese Ausbildung ist insbesondere für die Ausführungen vorteilhaft, bei welchen die zum Motor führenden Leitungen aus einem Faradayschen Käfig herausgeführt werden müssen.

In einer konstruktiv einfachen, jedoch hinsichtlich der EMV hochwirksamen Anordnung ist neben den elektrische Leistung führenden Leitern nur der Eingangsstörfilter in einem anderen Faradayschen Käfig angeordnet. Hierdurch kann wirksam verhindert werden, dass aus dem Leistungsteil kommende elektrostatische und/oder elektromagnetische Störungen in den Eingangsstörfilter einstrahlen.

Gemäß einer alternativen vorteilhaften Ausgestaltung der Erfindung kann es vorteilhaft sein, den Stator des elektrischen Motors, die Leistung führenden Leiter zwischen dem Stromrichter und dem elektrischen Motor und den Leistungskreis des Stromrichters in einem gemeinsamen Faradayschen Käfig anzuordnen. Ein solcher gemeinsamer Faradayscher Käfig kann vorteilhaft durch das metallische Motorgehäuse oder alternativ eine entsprechende Abschirmung des Stators, eine Kabelabschirmung der Leitung zwischen Motor und Stromrichter sowie einen Faradayschen Käfig, der die Stromrichterumhausung oder ein Teil davon bildet, gebildet werden.

Zweckmäßiger- aber nicht notwendigerweise sind die Faradayschen Käfige des Stromrichters und gegebenenfalls auch des Motors elektrisch miteinander verbunden und vorzugsweise mit dem Erdpotential verbunden. Besonders vorteilhaft ist es, wenn die Stromrichterumhausung drei Faradaysche Käfige aufweist, und zwar einen, in dem mindestens der Leistungsteil des Stromrichters angeordnet ist, einen anderen, für einen Eingangsstörfilter und einen weiteren, in dem der Schnittstellenkreis des Stromrichters angeordnet ist. Durch diese Anordnung kann die EMV des so ausgestatteten Stromrichters weiter verbessert werden.

Wenn, was bei der Verschaltung elektronischer Komponenten häufig der Fall ist, im Stromrichter eine Leiterplatte mit darauf angeordneten elektronischen Bauelementen vorgesehen ist, die durch Leiterbahnen an der Oberseite der Leiterplatte verbunden sind, sind gemäß einer vorteilhaften Weiterbildung der Erfindung mindestens einige elektronische Bauelemente von mindestens einem Faradayschen Käfig umschlossen, wobei eine leitende Schicht der Leiterplatte eine Wand des Faradayschen Käfigs bildet. Wenn also die Bauelemente durch Leiterbahnen an der Oberseite miteinander verbunden sind, dann ist diese leitende Schicht typischerweise eine darunter befindliche oder aber eine Schicht an der Unterseite der Leiterplatte.

Wenn, was vorteilhaft ist, die elektronischen Bauelemente in von einander getrennten Bereichen der Leiterplatte angeordnet sind, sind vorteilhaft ein oder mehrere dieser getrennten Bereiche von einem oder auch mehreren Faradayschen Käfigen umschlossen, wobei eine leitende Fläche der Platte eine Wand der Faradayschen Käfige bildet. Es können also an der einen Seite der Leiterplatte mehrere Faradaysche Käfige nebeneinander angeordnet werden, wobei vorteilhaft benachbarte Faradaysche Käfige je eine gemeinsame Wand aufweisen und die untere Wand der Käfige durch eine leitende Fläche der Leiterplatte gebildet wird, beispielsweise eine Zwischenschicht oder eine leitende Schicht an der Unterseite.

Alternativ oder zusätzlich können elektronische Bauelemente auf der Ober- und der Unterseite der Leiterplatte angeordnet sein, wobei sich Faradaysche Käfige zu beiden Seiten der Leiterplatte erstrecken können und eine leitende Schicht innerhalb der Leiterplatte eine Wand der Faradayschen Käfige auf beiden Seiten bildet. Die Leiterplatte ist dann eine Mehrlagenleitplatte.

Es können also gemäß der Erfindung Faradaysche Käfige auf einer Platinenseite nebeneinander und/oder auf beiden Platinenseiten einzeln oder nebeneinander angeordnet sein. Gemäß einer Weiterbildung der Erfindung kann ein Faradayscher Käfig sich auch zu beiden Seiten einer Leiterplatte erstrecken, die Leiterplatte ist dann vorteilhaft auf beiden Seiten mit elektronischen Bauelementen bestückt und durch elektrische Leiter (wire holes) verbunden, welche die Leiterplatte durchsetzen. Dann erstreckt sich der Faradaysche Käfig durch die Leiterplatte selbst hindurch.

Besonders vorteilhaft wird die Ausbildung des erfindungsgemäßen Stromrichters eingesetzt für einen Frequenzumrichter eines elektrischen Antriebsmotors einer Kreiselpumpe, dessen Umhausung an oder auf der Motor- und/der Pumpenumhausung angeordnet ist, sodass die in der Umhausung des Frequenzumrichters gebildeten Faradayschen Käfige in einfacher Weise gegebenenfalls mit dem Motorgehäuse und/oder dem Pumpengehäuse elektrisch leitend verbunden werden können. Als Antriebsmotor dient vorteilhaft ein Asynchronmotor oder ein Permanentmagnetmotor.

Die Erfindung ist nachfolgend anhand von in der Zeichnung dargestellten Ausführungsbeispielen näher läutert. Es zeigen:
- Fig. 1: ein Schaltbild eines mit einem Eingangsentstörfilter aussgerüsteten Frequenzumrichters gemäß der Erfindung mit angeschlossenem Motor, bei dem der Motor über ein Kabel mit dem Frequenzumrichter verbunden ist,
- Fig. 2: eine alternative Ausführung in Darstellung nach Fig. 1, bei der der Motor und der Frequenzumrichter in einer gemeinsamen Umhausung angeordnet sind,
- Fig. 3a: das Schaltbild eines Eingangsentstörfilters einer ersten Ausführungsform,
- Fig. 3b: das Schaltbild eines Eingangsstörfilters gemäß einer zweiten Ausführungsform,
- Fig. 4: im Schnitt die Verbindung zweier Faradayscher Käfige durch eine Mehrschichtenleiterplatte,
- Fig. 5: einen Schnitt längs der Schnittlinie V-V in Fig. 4 und
- Fig. 6: einen Schnitt längs der Schnittlinie VI-VI in Fig. 5.

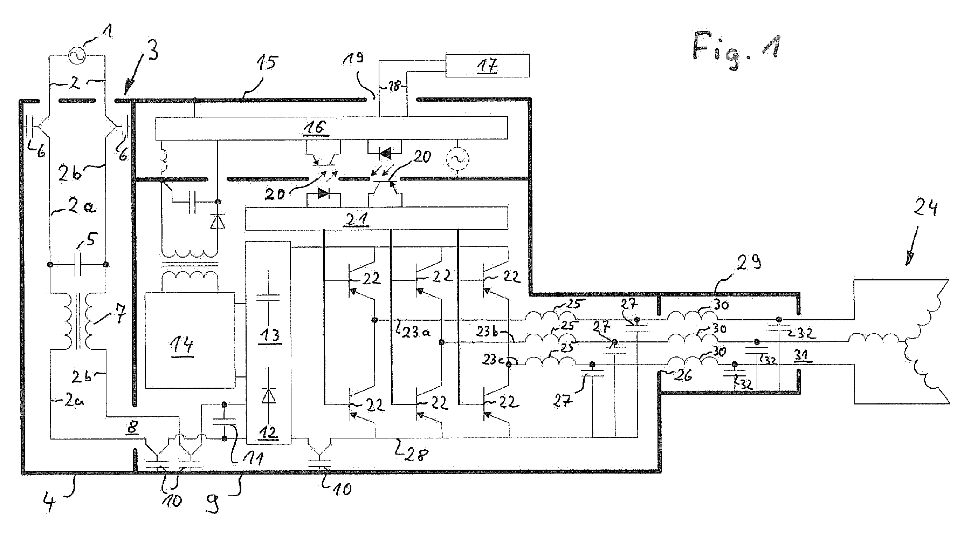

Der in Fig. 1 dargestellte Frequenzumrichter ist zum Anschluss an ein Wechselstromnetz 1 vorgesehen. In der Figur ist eine einphasige Version aus Gründen der besseren Übersichtlichkeit dargestellt, es versteht sich, dass nach dem gleichen Bauprinzip durch Hinzufügen entsprechender Leitungen und Bauteile auch eine mehrphasige Versorgung vorgesehen sein kann. Die an das Wechselstromnetz 1 anzuschließende Versorgungsleitung 2 ist zunächst durch einen Eingangsentstörfilter 3 geführt, der in einem ersten Faradayschen Käfig 4 angeordnet ist bzw. durch diesen abgeschirmt ist. Innerhalb des Eingangsentstörfilters 3 sind die beiden Leiter 2a und 2b mittels eines Kondensators 5 miteinander verbunden, bei dem es sich um einen X2-Kondensator handelt. Die Leiter 2a und 2b der Versorgungsleitung 2 sind weiterhin innerhalb des ersten Faradayschen Käfigs 4 jeweils über einen Kondensator 6 mit dem Faradayschen Käfig 4 leitend verbunden.

Schließlich sind die Leiter 2a und 2b, nachdem sie zum Zwecke des Kurzschlusses der hohen Frequenzen den Kondensator 5 passiert haben, einer Gleichtaktdrossel (CMC) 7 zugeführt, und zwar der Leiter 2a der einen Seite der Drossel und der Leiter 2b der anderen Seite der Drossel 7, bevor sie durch eine Öffnung 8 in der Wand des ersten Faradayschen Käfigs 4 in einem zweiten Faradayschen Käfig 9 geführt sind. Nahe der Öffnung 8 sind die Leiter 2a und 2b jeweils über einen Kondensator 10 mit dem zweiten Faradayschen Käfig 9 leitungsverbunden, bei den Kondensatoren 10 handelt es sich um Y2-Kondensatoren. Weiterhin sind die Leiter 2a und 2b eingangsseitig des zweiten Faradayschen Käfigs 9 durch einen Kondensator 11 verbunden, der ebenso wie der Kondensator 5 ein X2-Kondensator ist.

Die Versorgungsleitung 2 ist nachfolgend einem Gleichrichterkreis 12 zugeführt, dessen Ausgang einen Zwischenkreis 13 in an sich bekannter Weise speist, sowie darüber hinaus ein Schaltnetzteil 14, welches zur Spannungsversorgung eines in einem dritten Faradayschen Käfig 15 angeordneten Schnittstellenkreises 16 vorgesehen ist. Der Schnittstellenkreis 16 umfasst einen außerhalb des dritten Faradayschen Käfigs 15 angeordneten Sensor 17, der über eine Leitung 18, durch eine Öffnung 19 mit dem Schnittstellenkreis 16 innerhalb des dritten Faradayschen Käfigs 15 verbunden ist. Die Signale des Schnittstellenkreises 16 werden mittels in der Wand zwischen dem dritten und dem zweiten Faradayschen Käfig eingegliederten Optokopplern 20 drahtlos übertragen und dann von einem Mikrokontroller 21 aufgenommen, der innerhalb des zweiten Faradayschen Käfigs 9 angeordnet ist und der sechs Leistungsschalter 22 steuert, welche jeweils paarweise den Leitern 23a, 23b und 23c zugeordnet sind, welche die Versorgungsleitungen für die drei Phasen des daran angeschlossenen elektrischen Motors 24 bilden. Der Schnittstellenkreis 16 dient zum Anschluss einer oder mehrerer Sensoren und zum Anschluss einer oder mehrerer Datenübertragungskabel oder drahtloser Datenverbindungen. Die Verbindung zwischen dem Schnittstellenkreis 13 und dem Mikrokontroller 21 des Frequenzumrichters ist durch die hier beispielhaft dargestellten Optokoppler 20 oder Übertrager galvanisch isoliert. Die galvanische Isolierung ist idealerweise in einer Öffnung zwischen zwei Faradayschen Käfigen angeordnet. Die Spannungsversorgung für den Schnittstellenkreis 16 muss ebenfalls mittels eines Kondensators zum Faradayschen Käfig entkoppelt werden, der möglichst nahe an der Öffnung angeordnet ist, durch welche das Versorgungskabel durch die Wand geführt ist.

Die Leiter 23a, 23b und 23c sind jeweils durch eine Drossel 25 geführt und unmittelbar vor dem Herausführen der Leiter durch eine Öffnung 26 in dem zweiten Faradayschen Käfig 9 über Kondensatoren 27 mit einer Leitung 28 verbunden, die wiederum über einen Kondensator 10 mit dem zweiten Faradayschen Käfig 9 leitend verbunden ist. Die Kondensatoren 27 sind X2-Kondensatoren.

Die Leiter 23 in dem zweiten Faradayschen Käfig 9, der den Eingangs-, Zwischen- und Leistungskreis des Frequenzumrichters aufnimmt, sind über eine Öffnung 26 in einen vierten Faradayschen Käfig 29 geführt, der einen Ausgangsfilterkäfig bildet, in welchem jeder der Leiter 23a, 23b und 23c zunächst eine Drossel 30 durchläuft und unmittelbar vor seinem Ausgang über eine Öffnung 31 mit einem Kondensator 32 verbunden ist, dessen andere Seite mit dem vierten Faradayschen Käfig 29 leitungsverbunden ist. Die Kondensatoren 32 sind Y2-Kondensatoren.

Die Faradayschen Käfige 4, 9, 15 und 29 sind leitend miteinander und mit dem Erdpotential verbunden. Sie haben, wie das Schaubild nach Fig. 1 verdeutlicht, teilweise gemeinsame Wände und sind durch eine metallische Haut oder durch ein sehr engmaschiges Netz, z. B. Kupfergase, gebildet. Sie können Teil des Frequenzumrichtergehäuses sowie einer oder mehrerer Leiterplatten bilden, auf welchen die Bauelemente angeordnet und verschaltet sind.

Die Fig. 1 zeigt eine Ausführungsform, bei welcher der Frequenzumrichter als eine aus mehreren Faradayschen Käfigen aufgebaute Einheit besteht, deren Eingang durch die Versorgungsleitung 2 und deren Ausgang durch die Leiter 23a, 23b und 23c gekennzeichnet ist, die den Motor 24 versorgen.

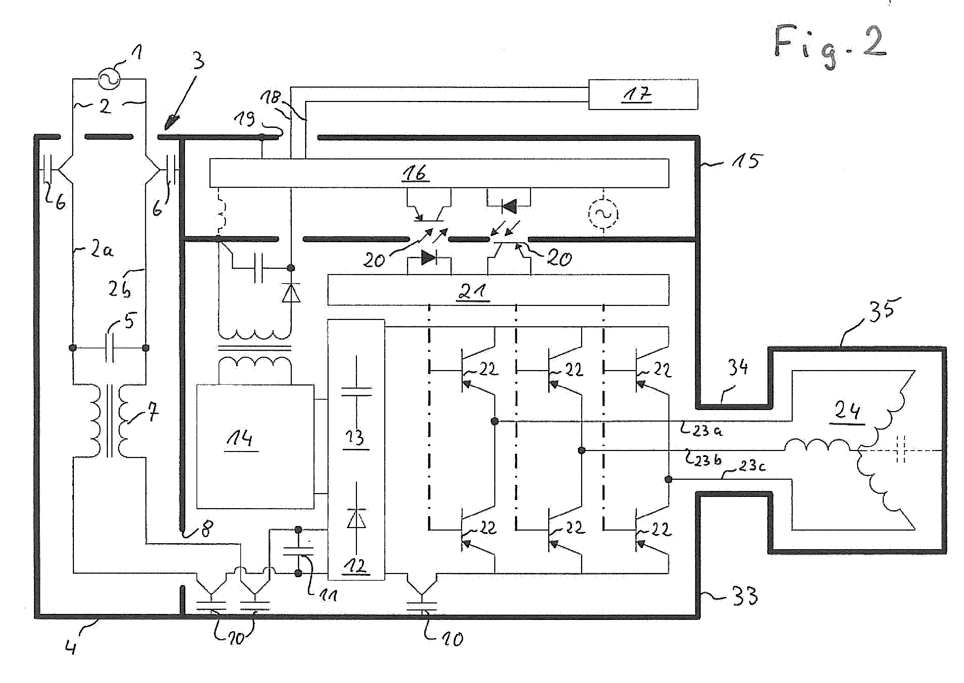

Bei der anhand von Fig. 2 dargestellten Ausführungsvariante, die, soweit es den ersten und dritten Faradayschen Käfig 4 und 15 angeht, identisch mit der vorbeschriebenen Ausführung übereinstimmt, umfasst der dritte Faradaysche Käfig, der in Fig. 2 mit 33 gekennzeichnet ist, darüber hinaus noch den Motor 24 sowie die Leitungsführung zum Motor. Dabei ist die Leitungsführung durch eine gemeinsame Leitungsabschirmung 34 gebildet, die einerseits mit dem dritten Faradayschen Käfig 33 verbunden ist und an diesen anschließt, sowie andererseits an ein Statorgehäuse 35, welches den Stator des Motors 24 abschirmt und somit Teil des dritten Faradayschen Käfigs 33 bildet. Wie das Schaltbild nach Fig. 2 verdeutlicht, ermöglicht eine solche Anordnung einen Verzicht auf die Drosseln 25 und 30 sowie die Kondensatoren 27 und 32 gemäß der Ausführungsform nach Fig. 1, also der Ausgangsentstörfilter ist dadurch entbehrlich.

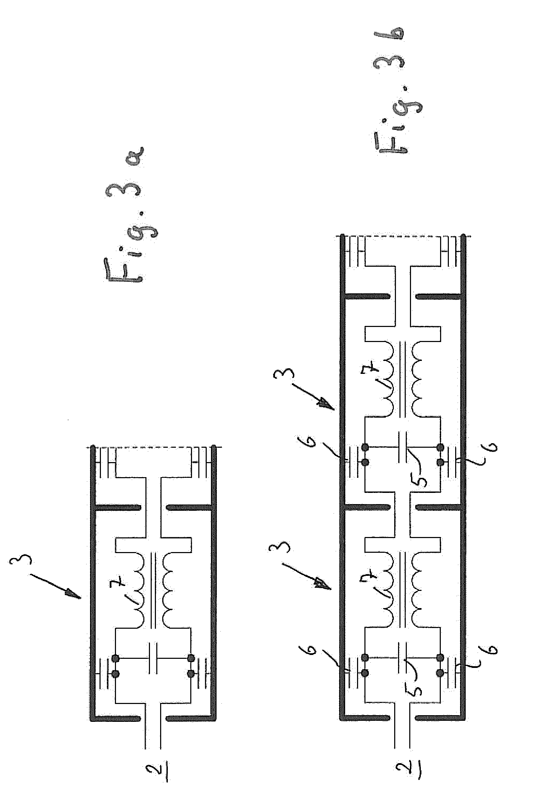

Beiden Ausführungen gemeinsam ist, dass stets der Leistungskreis in einem gesonderten Faradayschen Käfig angeordnet ist, da der Leistungskreis im gesamten Frequenzumrichter die größte elektromagnetische/elektrostatische Störquelle bildet. Davon getrennt, ist der besonders empfindliche Schnittstellenkreis, der in dem dritten Faradayschen Käfig 15 angeordnet ist. Schließlich ist ebenfalls vom Leistungskreis getrennt der Faradaysche Käfig, der den Eingangsstörfilter bildet. Wie dieser im Einzelnen aufgebaut ist, ergibt sich auch aus Fig. 3a, dem darunter eine Fig. 3b gegenübergestellt ist, die eine dem gegenüber noch weiter verbesserte Ausführungsform darstellt. Bei der Ausführungsvariante gemäß Fig. 3b sind zwei Eingangsentstörfilter 3 in Reihe hintereinander geschaltet, wodurch die elektromagnetische Verträglichkeit des Frequenzumrichters weiter verbessert wird.

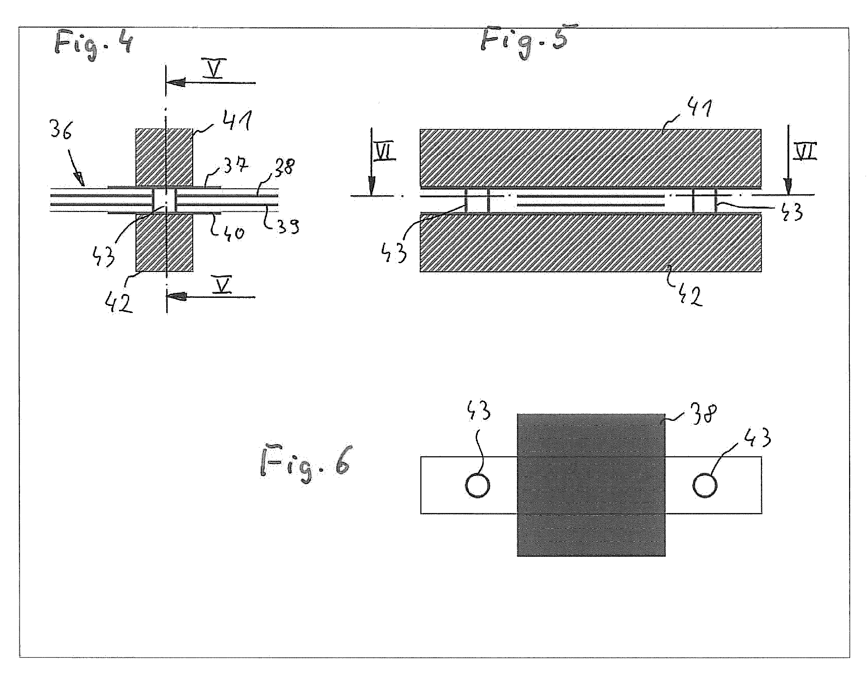

Die anhand der Figuren 1 bis 3 dargestellten Schaltbilder veranschaulichen im Wesentlichen die elektrische Anordnung und Verschaltung der Bauelemente. Wie diese auf einer oder mehreren Leiterplatten in unterschiedlichen Faradayschen Käfigen anzuordnen sind, ist bereits einleitend beschrieben worden, der konstruktiven Vielfalt sind hier kaum Grenzen gesetzt. Insbesondere bei Verwendung von mehrschichtig aufgebauten Leiterplatten kann vorteilhaft eine leitende Plattenschicht Teil eines oder auch mehrerer Faradayscher Käfige bilden. Auch kann ein Faradayscher Käfig durch eine Platine hindurch verlaufen, wie dies anhand der Figuren 4 bis 6 im Einzelnen dargestellt ist.

Die in den Figuren 4 bis 6 dargestellte Mehrlagenleiterplatte 36 weist insgesamt vier elektrisch leitende Schichten 37, 38, 39 und 40 auf, die jeweils für sich zur Verdrahtung von darauf oder darunter angeordneten elektronischen Bauelementen genutzt werden können. Wenn die elektrisch leitende Schicht 37 an der Oberseite bzw. die elektrisch leitende Schicht 40 an der Unterseite in an sich bekannter Weise Leiterbahnen für die an der Oberseite angeordneten bzw. an der Unterseite angeordneten Bauelemente bilden, können sowohl an der Oberseite ein oder mehrere Faradaysche Käfige gebildet werden, die nach unten hin durch eine elektrisch leitende Schicht 38 abgeschlossen werden, als auch an der Unterseite angeordnete Faradaysche Käfige, die durch die leitende Schicht 39 nach oben abgeschlossen werden.

Anhand der Figuren 4 bis 6 ist dargestellt, wie ein auf der Oberseite der Leiterplatte vorgesehener Faradayscher Käfig 41 mit einem dazu fluchtend an der Unterseite der Leiterplatte vorgesehenen Faradayschen Käfig 42 durch die Leiterplatte hindurch elektrisch leitend verbunden wird, um so einen gemeinsamen, einen Abschnitt der Leiterplatte einschließenden Faradayschen Käfig 41, 42 zu bilden. Die Verbindung der Käfige 41 und 42 erfolgt durch Leiterdurchführungen (wire holes) 43 und davon ausgehend in der leitenden Schicht 37 an der Oberseite bzw. der leitenden Schicht 40 an der Unterseite angeordneten umlaufenden Leiterbahnen, an denen die Wände der Faradayschen Käfige 41 und 42 kontaktiert sind. In einem bestimmten Abstand zueinander sind diese Leiterdurchführungen 43 vorgesehen, welche durch eine die Platte 36 durchsetzende Bohrung gebildet sind, in deren Wandung eine elektrisch leitende Schicht aufgebracht ist, die mit der elektrisch leitenden Schicht 37 an der Oberseite sowie der elektrisch leitenden Schicht 40 an der Unterseite der Platine in einem Bereich verbunden ist. Die zwischen den elektrisch leitenden Schichten 37 und 40 an der Ober- bzw. Unterseite der Platine 36 angeordneten elektrisch leitenden Schichten 38 und 39 sind im Bereich dieser Leiterdurchführungen 43 ausgespart und können somit für andere elektrische Verbindungen genutzt werden.

### Bezugszeichenliste

- 1: Wechselstromnetz
- 2: Versorgungsleitung mit den Leitern 2a und 2b
- 2a: Phase
- 2b: Nullleiter
- 3: Eingangsentstörfilter
- 4: erster Faradayscher Käfig
- 5: Kondensator X2
- 6: Kondensator Y2
- 7: Gleichtaktdrossel (CMC)
- 8: Öffnung
- 9: zweiter Faradayscher Käfig
- 10: Kondensator Y2
- 11: Kondensator X2
- 12: Gleichrichterkreis
- 13: Zwischenkreis
- 14: Schaltnetzteil
- 15: dritter Faradayscher Käfig
- 16: Schnittstellenkreis
- 17: Sensor
- 18: Leitung
- 19: Öffnung
- 20: Optokoppler
- 21: Mikrokontroller
- 22: Leistungsschalter
- 23a, b, c: Leiter
- 24: Motor
- 25: Drossel
- 26: Öffnung
- 27: Kondensator X2
- 28: Leitung
- 29: vierter Faradayscher Käfig
- 30: Drossel
- 31: Öffnung
- 32: Kondensator Y2
- 33: dritter Faradayscher Käfig (Fig. 2)
- 34: Leitungsabschirmung
- 35: Statorgehäuse
- 36: Mehrlagenleiterplatte
- 37: elektrisch leitende Schicht von 36
- 38: elektrisch leitende Schicht von 36
- 39: elektrisch leitende Schicht von 36
- 40: elektrisch leitende Schicht von 36
- 41: Faradayscher Käfig oben
- 42: Faradayscher Käfig unten
- 43: Leiterdurchführungen (wire holes)

## Patentansprüche

1. Stromrichter, insbesondere Frequenzumrichter, mit einer Umhausung, in welcher elektrische und elektronische Bauelemente (5, 6, 7, 22) angeordnet sind und die zumindest teilweise als Faradayscher Käfig ausgebildet ist, **dadurch gekennzeichnet, dass** die Umhausung mindestens zwei Faradaysche Käfige (4, 9, 15, 29) aufweist.

2. Frequenzumrichter nach Anspruch 1, **dadurch gekennzeichnet, dass** zwei getrennte Faradaysche Käfige (4, 9) eine gemeinsame Käfigwand aufweisen.

3. Frenquenzumrichter nach Anspruch 1 oder 2, **dadurch gekennzeichnet, dass** ein oder mehrere Bauelemente (22), welche im Betrieb eine elektromagnetische und/oder elektrostatische Störquelle bilden, in zumindest einem Faradayschen Käfig (9) und ein oder mehrere Bauelemente (16), welche empfindlich für den Empfang von elektromagnetischen und/oder elektrostatischen Störsignalen sind, in mindestens einem anderen Faradayschen Käfig (15) angeordnet sind.

4. Stromrichter nach einem der vorhergehenden Ansprüche, **dadurch gekennzeichnet, dass** mindestens die elektronischen Schalter (22) des Leistungskreises des Stromrichter in dem einen eigenen Faradayschen Käfig (9) angeordnet sind.

5. Stromrichter nach einem der vorhergehenden Ansprüche, **dadurch gekennzeichnet, dass** mindestens einer oder eine Anzahl von Eingangs- und/oder Ausgangsstörfiltern in voneinander getrennten Faradayschen Käfigen (4, 29) angeordnet sind.

6. Stromrichter nach einem der vorhergehenden Ansprüche, **dadurch gekennzeichnet, dass** ein Durchführungskondensator (feed through capacitor) in einer Wand zwischen zwei Faradayschen Käfigen vorgesehen ist, um ein elektrisches Signal und/oder elektrische Leistung von einem Käfig in den anderen Käfig zu führen.

7. Stromrichter nach einem der vorhergehenden Ansprüche, **dadurch gekennzeichnet, dass** mindestens ein Kondensator (10) an einer Seite elektrisch mit der Wand des Faradayschen Käfigs (9) nahe der Durchführungsöffnung (8) und an der anderen Seite elektrisch mit dem Leiter (2) verbunden ist, welcher durch die Durchführungsöffnung (8) von einem Faradayschen Käfig (4) zum anderen Faradayschen Käfig (9) verläuft.

8. Stromrichter nach Anspruch 7, **dadurch gekennzeichnet, dass** der mindestens eine Kondensator (10), der elektrisch mit dem Leiter (2) und der Wand des Käfigs (9) verbunden ist, in dem ein Störsignal entsteht oder geführt wird.

9. Stromrichter nach einem der vorhergehenden Ansprüche, **dadurch gekennzeichnet, dass** ein gesonderter Faradayscher Käfig (29) vorgesehen ist, der einen Ausgangsfilterkäfig des Stromrichters bildet, der zwei oder mehr leistungsführende Leiter (23) zu einem Motor (24) und mindestens einen Kondensator (32) aufweist, welcher zwischen einem Leiter (23) und der Wand des Ausgangsfilterkäfigs (29) geschaltet ist.

10. Stromrichter nach Anspruch 5, **dadurch gekennzeichnet, dass** neben den elektrische Leistung führenden Leitern nur der Eingangsstörfilter (3) in einem anderen Faradayschen Käfig (4) angeordnet ist.

11. Stromrichter nach Anspruch 10, **dadurch gekennzeichnet, dass** der Stator des elektrischen Motors (24), die Leistung führenden Leiter (23) zwischen dem Stromrichter und dem elektrischen Motor (24) und der Leistungskreis des Stromrichters von einem gemeinsamen Faradayschen Käfig (33, 34, 35) umschlossen sind.

12. Stromrichter nach Anspruch 11, **dadurch gekennzeichnet, dass** ein gemeinsamer Faradayscher Käfig durch das metallische Motorgehäuse (35) oder eine Abschirmung des Motors, eine Kabelschirmung (34) und einen Faradayscher Käfig (33) der Stromrichterumhausung gebildet ist.

13. Stromrichter nach einem der vorhergehenden Ansprüche, **dadurch gekennzeichnet, dass** die Faradayschen Käfige (4, 9, 15, 29) elektrisch und vorzugsweise mit Erdpotential verbunden sind.

14. Stromrichter nach einem der vorhergehenden Ansprüche, **dadurch gekennzeichnet, dass** die Stromrichterumhausung drei Faradaysche Käfige aufweist, einen für mindestens den Leistungsteil, einen anderen für einen Eingangsentstörfilter und einen weiteren für den Zwischenkreis des Stromrichters.

15. Stromrichter nach einem der vorhergehenden Ansprüche, **dadurch gekennzeichnet, dass** eine Leiterplatte (36) mit darauf angeordneten elektronischen Bauelementen vorgesehen ist, die durch Leiterbahnen (37) an der Oberseite der Platte (36) verbunden sind, wobei mindestens einige elektronische Bauelemente von mindestens einem Faradayschen Käfig (41) umschlossen sind und eine leitende Schicht (38) der Platte (36) eine Wand des Faradayschen Käfigs bilden.

16. Stromrichter nach Anspruch 15, **dadurch gekennzeichnet, dass** die elektronischen Bauelemente in voneinander getrennten Bereichen der Leiterplatte (36) angeordnet sind, wobei ein oder mehrere dieser getrennten Bereiche von einem oder mehreren Faradayschen Käfigen (41) umschlossen sind und eine leitende Fläche (38, 39) der Platte (36) eine Wand der Faradayschen Käfige bildet.

17. Stromrichter nach Anspruch 15 oder 16, **dadurch gekennzeichnet, dass** die elektronischen Bauelemente auf der Ober- und der Unterseite der Leiterplatte (36) angeordnet ist, wobei die Leiterplatte (36) eine Mehrlagenleiterplatte ist, mit Faradayschen Käfigen (41, 42) zu beiden Seiten der Platte und einer leitenden Schicht (38, 39) innerhalb der Platte, die eine Wand der Faradayschen Käfige auf beiden Seiten bildet.

18. Stromrichter nach einem der vorhergehenden Ansprüche, **dadurch gekennzeichnet, dass** eine Leiterplatte (36) mit elektronischen Bauelementen auf beiden Seiten der Platte vorgesehen ist, die von einem Faradayschen Käfig (41, 42) umschlossen sind, wobei die Wände des Käfigs auf der Ober- und der Unterseite der Leiterplatte (36) angeordnet und elektrisch durch die Leiterplatte (36) verlaufende Leiter (43) miteinander verbunden sind.

19. Stromrichter nach einem der vorhergehenden Ansprüche, **dadurch gekennzeichnet, dass** der Stromrichter ein Frequenzumrichter für einen elektrischen Antriebsmotor (24) einer Kreiselpumpe ist und dass die Umhausung des Frequenzumrichters an oder auf der Motor- und/oder Pumpenumhausung angeordnet ist.
